# EUROPEAN PATENT APPLICATION

(11) **EP 4 819 769 A1**
(43) Date of publication of application: **07.10.2026**
(21) Application number: 26167310.7
(22) Date of filing: 24.03.2026
(51) Int. Cl.: H05K 1/11, H05K 1/02

(54) **COMPONENT CARRIER WITH AT LEAST ONE OPENING AND METHOD OF MANUFACTURING A COMPONENT CARRIER**

(30) Priority: 31.03.2025 CN 202510396946
(71) Applicant: AT & S Austria Technologie & Systemtechnik Aktiengesellschaft, 8700 Leoben-Hinterberg (AT)
(72) Inventor: WANG, Nina, Chongqing, 401133 (CN); BAFTIRI, Artan, 8010 Graz (AT)
(74) Representative: Dilg, Haeusler, Schindelmann Patentanwaltsgesellschaft mbH

(57) **Abstract**

There is described a component carrier (100) and a method of manufacturing a component carrier. The component carrier comprises:
at least one electrically insulating layer structure (106) and at least one electrically conductive layer structure (104);
wherein said at least one insulating layer structure (106) comprises at least one opening (108) which connects a main surface (101) of the at least one electrically insulating layer structure (106) with at least part of the at least one electrically conductive layer structure (104), said at least one opening (108) being delimited by a lateral wall (109), said lateral wall (109) comprising two portions, a first portion (109a) and a second portion (109b), one above the other in a thickness direction of the at least one insulating layer structure (106), wherein said two portions (109a, 109b) have a different extension one to each other in the thickness direction of the at least one insulating layer structure (106).

## Description

### Field of the Invention

The invention relates to a component carrier comprising at least one electrically insulating layer structure and at least one electrically conductive layer structure. The component carrier further comprises at least one opening which connects a main surface of the at least one electrically insulating layer structure with at least part of the at least one electrically conductive layer structure. Said at least one opening is delimited by a lateral wall which comprises a first portion and a second portion. The two portions have a different extension one to each other. The invention further relates to a method of manufacturing such a component carrier.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

For some applications there are connections required to connect a component carrier with other devices, for example with IC-chips or other component carriers. For such connections solder bumps or solder balls can be provided. Solder bumps can be put on top of small electrically conductive elements on the main surface of a component carrier. For the connection of the component carrier with another device, the other device is put on the solder bumps and a soldering processes performed. Since solder bumps require only little surface area, the use of solder bumps for connections allows a high package density of connections.

Since the solder bumps are situated on the surface of component carrier, there has to be provided a connection from the solder bumps to electrically conductive structures within the component carrier. A possibility to connect a solder bump with an electrically conductive structure within the component carrier is to provide a via through at least one electrically insulating structure which forms part of the main surface of the component carrier. Such a via can be provided by drilling a hole into the electrically insulating structure which connects a main surface with an electrically conductive structure within the component carrier. After drilling, the hole can be filled with electrically conductive material, for example by electroplating. However, the current technology to manufacture a via for connection with the solder bump has some drawbacks: during drilling of the hole, for example by laser drilling, the electrically insulating layer structure may be damaged or delamination may occur. Furthermore, the drilling might leave back residues of the electrically insulating layer structure within the hole, in particular at the bottom of the via adjacent to the electrically conductive structure within the component carrier. Such residues may extend toward and into the bottom of the hole to form a foot structure, which may reduce the reliability of the via. For example, by the residues in form of a foot structure there might be a risk of a crack in the via. Furthermore, due to the drilling process, the hole might not have a regular shape. In many cases the size of the hole next to the main surface is bigger than the size of the hole adjacent to the electrically conductive structure. The shape of the drilled hole might for example be conical. Such a conical shape of the drill hole occurs, for example, when laser drilling is performed. The irregular shape of the whole may lead to an irregular shape of the via connecting the solder bump with the electrically conductive structure. Such an irregular shape of the via may lead to an inferior signal integrity performance of the connection.

### Summary of the Invention

There may be a need to provide an improved connection of an electrically conductive structure within a component carrier to an electrically conductive structure at a surface of the component carrier. An electrically conductive structure at a surface of the component carrier can, for example, be a solder bump.

A component carrier and a method of manufacturing a component carrier are described.

According to an aspect of the invention, there is described a component carrier (e.g. a printed circuit board or an IC substrate), comprising:
at least one electrically insulating layer structure (e.g. a reinforced/non-reinforced resin layer or a protective layer) and at least one electrically conductive layer structure (e.g. a metal layer). The at least one insulating layer structure comprises at least one opening (e.g. a hole) which connects a main surface of the at least one electrically insulating layer structure with at least part of the at least one electrically conductive layer structure. The at least one opening is delimited by a lateral wall (which may surround the opening). The lateral wall comprises two portions, a first portion and a second portion, one above the other in a thickness direction of the at least one insulating layer structure. The two portions have a different extension (e.g. a different shape or size) one to each other in the thickness direction of the at least one insulating layer structure.

According to a further aspect of the invention, there is described a method of manufacturing a component carrier (e.g. as described above), wherein the method comprises:
forming a stack comprising at least one electrically conductive layer structure and at least one electrically insulating layer structure;
forming least one opening which connects a main surface of the at least one electrically insulating layer structure with at least part of the at least one electrically conductive layer structure, said at least one opening being delimited by a lateral wall, said lateral wall comprising two portions, a first portion and a second portion, one above the other in a thickness direction of the at least one insulating layer structure.

The two portions have a different extension one to each other in the thickness direction of the at least one insulating layer structure.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. In particular, a component carrier may also be embodied as a flexible or semi-rigid substrate. A component carrier may also be a hybrid board combining different ones of the above mentioned types of component carriers. The term "component carrier" comprises the finished component carrier with all its functions already manufactured. The term "component carrier" also comprises any preforms of a finished component carrier which occur between the manufacturing steps. A component carrier may also be a panel comprising a plurality of non-finished or finished printed circuit boards (PCBs).

In the context of the present application, the term "stack" may particularly denote an arrangement of multiple planar layer structures which are mounted in parallel on top of one another. For example, the stack may be a laminated stack, i.e. comprising a plurality of layer structures connected by the application of heat and/or pressure.

In the context of the present application, the term "layer structure" may particularly denote a continuous layer, a patterned layer or a plurality of nonconsecutive islands within a common plane.

In the context of the present application, the term "main surface" of a body (such as the stack) may particularly denote one of two largest opposing surfaces of the body or an external layer surface of the stack. The main surfaces may be connected by circumferential side walls. The thickness of a body, such as a stack, may be defined by the vertical distance between the two opposing main surfaces.

In the context of the present application, the term "opening" may particularly denote a cavity or a via or a recess within the layer structure. The cavity, via or recess may extend through the layer so that a central axis or a symmetry axis of the cavity is perpendicular or substantially perpendicular to parallel main surfaces of the layer or stack. The opening can be an empty space or can be filled with material, for example electrically conductive material.

In the context of the present application, the term "lateral wall" may particularly denote a wall bordering the opening in the layer structure in thickness direction. The lateral wall may have different portions. At least portions of the lateral wall may be straight or curved (for instance in a concave and/or convex fashion).

In the context of the present application, the terms "first portion" and "second portion" may particularly denote different portions or parts of the lateral wall of the opening. There might be a boundary between the first portion and the second portion. For example, such a boundary may be situated between different profiles (extension, dimension) or different properties (roughness) of the two portions.
Since the first portion and the second portion of the lateral wall surround or border a part or portion of the opening respectively, also two different parts or portions of the opening may be denoted as "first portion" and "second portion".

In the context of the present application, the term "thickness direction of the at least one insulating layer structure" may particularly denote a direction which is orientated perpendicular to at least one main surface of the at least one insulating layer structure. Preferably, the at least one insulating layer structure comprises two opposing main surfaces which are orientated parallel to each other.

According to an exemplary embodiment, the invention may be based on the idea to provide an opening with an improved shape in an electrically insulating layer structure to improve the via integrity. The improved shape has advantages regarding signal integrity performance and reliability of the connection and the component carrier. To improve the shape of the opening, the opening is manufactured in at least two different manufacturing steps, preferably in two successive manufacturing steps. As a result of manufacturing an opening in at least two manufacturing steps, the opening or its lateral wall comprises two portions, a first portion and the second portion, wherein these two portions have a different extension one to each other in the thickness direction of the at least one insulating layer structure. The two portions, which differ from each other in their extension or shape, are a footprint of the at least two manufacturing steps. This footprint is visible at the component carrier, in a semifinished state and in a finished state of the component carrier.

Starting from the at least one insulating layer structure which has not yet an opening, the opening is formed. The opening connects a main surface of the electrically insulating layer structure, in particular the main surface of the electrically insulating layer structure opposed to the at least one electrically conductive structure, with the at least one electrically conductive layer structure. Thus, the opening provides a passage from the main surface of the electrically insulating layer structure to the electrically conductive layer structure. According to an idea of the invention, the opening is divided into two portions with different extensions in the thickness direction. According to prior art, an opening may be provided, for example by laser drilling, which provides only one extension in the thickness direction. An opening formed by laser drilling usually has a conical shape which leads to a conical via after filling the opening with electrically conductive material. Furthermore, an opening only formed by laser drilling comprises a constant extension or property of the lateral wall of the opening. According to the invention, the two portions of the opening differ in their extension and thus allow to improve the shape of the opening regarding signal integrity performance and a reliable adhesion connection of electrically conductive material filled in the opening with the electrically insulating layer structure. The two portions can, for example, be shaped in a way that a conical shape of the whole opening is avoided or at least suppressed. The different extensions one to each other of the two portions can, for example, be achieved by using different manufacturing processes for each of the portions. For example, a first portion adjacent to the electrically conductive layer structure may be manufactured using a chemical etching or stripping process which allows an extension of the first portion, which is essentially a cylindrical. The second portion above the first portion and adjacent to the first portion may be manufactured by laser drilling and comprise a slight conical extension in the thickness direction. In this example, the two portions one above the other in the thickness direction together provide an improved shape, since the first portion is nearly cylindrical and the second portion has a less significant conical shape, because it only extends over a part of the depth of the opening in the thickness direction. The improved shape leads to improved signal integrity performance. Furthermore, in particular the area where the first portion at the second portion border each other, can improve the adhesion of electrically conductive material filled into the opening to provide a via. For example, areas of different roughness within the opening, in particular differences in roughness between the first portion and the second portion, can be used to improve adhesion of electrically conductive material filled within the opening. Furthermore, due to the two manufacturing steps used to form the opening, it is also possible to form an undercut in the opening which supports the adhesion between electrically conductive material filled within the hole and the insulating layer structure. It has turned out that the run rate can also be improved by dividing the opening into a first portion and a second portion. Thus, the described component carrier can be manufactured in less time than according to the prior art.

The described component carrier comprises an opening with the lateral wall which is constituted by two portions. These portions differ in the extension from each other and allow to shape the opening in an improved way compared with the shape of an opening merely constituted by one single portion. The improved shape of the opening according to the invention provides an improved connection of an electrically conductive structure within the component carrier to an electrically conductive structure at the surface of the component carrier.

The described method of manufacturing a component carrier allows to provide the described component carrier in a simple and reliable way. According to an idea of the invention, two portions of the lateral wall of an opening are formed to have a different extension one to each other in the thickness direction of the at least one insulating layer structure.

The described component carrier and the described method of manufacturing such a component carrier fulfills the need to provide an improved connection of an electrically conductive structure within a component carrier to an electrically conductive structure at a surface of the component carrier. In particular, an improved connection for a solder bump on the main surface of the component carrier can be provided.

### Exemplary Embodiments

In an embodiment, the different extension of the two portions is a different inclination one to each other with respect to the thickness direction of the at least one insulating layer structure. The two portions may differ from each other in their inclination. An inclination may mean that in a sectional view of the opening, the lateral wall is slanted. The first portion may have a smaller inclination than the second portion. Furthermore, the first portion may have no inclination but may comprise a cylindrical shape wherein the second portion may have an inclination and a comprise a conical shape The different shape or inclination of the two portions provides a flexibility and a tolerance for the design of the product or component carrier. At the same time, it provides an advantage that such kind of opening can improve the quality and reliability of product or component carrier.

In an embodiment, the different extension of the two portions is a different shape one to each other. Shape may refer to a form in the three-dimensional space. For example, the first portion may comprise the shape of a cylinder, wherein the second portion may comprise the shape of a cone. The shape may be regular and constant in the circumferential direction around the middle axis of the opening. It is also possible that the shape is irregular and not symmetrical around the middle axis of the opening. For example, at least one of the portions may not be symmetrical in top view on the at least one insulating layer structure. For example, the first portion may have a not symmetrical rectangular shape in such a top view, wherein the second portion may have a symmetrical shape of a circle Basically, the regular shape formed by this invention can increase the tolerance of the layout for density of the opening design. That means it may increase the density of the openings and allow to successfully produce the higher density electrically conductive layer structure by current technology without further investment. It does not only improve the yield and product quality, but it also reduces the cost of a more advanced product.

In an embodiment, the first portion is closer to the at least one electrically conductive layer structure and the second portion is closer to the main surface of the at least one electrically insulating layer structure. The first portion is defined to be closer to the electrically conductive layer structure. Moreover, the diameter of the first portion is increased compared with prior art, which provides a bigger channel for the signal transmission. Therefore, the resistance in the electrical path can be reduced. This improves the signal transmission efficiency and reduces the skin effect. Meanwhile, it can improve the conductive material filling uniformity and reduce the risk of a void, so that also the reliability is improved.

In an embodiment, the first portion and the second portion are situated adjacent to each other in the thickness direction of the at least one insulating layer structure. The first portion and a second portion may directly adjoin each other in the thickness direction. Alternatively, it is possible that between the first portion and a second portion there is an intermediate portion, which connects the first portion and a second portion The intermediate portion may provide a buffer zone for the thermal stress which is accumulated at or in the opening, so that the stress may be distributed more inside of the opening by the intermediate portion and it may reduce the risk of a crack issue.

In an embodiment, the planar extension of the first portion is different from the planar extension of the second portion in a direction perpendicular to the thickness direction of the at least one insulating layer structure. Planar extension is an extension in the direction perpendicular to the thickness direction and to the middle axis of the opening. Planar extension may indicate the area of the respective portion. Furthermore, the planar extension may also indicate the shape or the form of the portion in the plane perpendicular to the thickness direction. Thus, the first portion and the second portion are aligned, which means the opening with first portion and second portion has a more regular shape compared with the state of art. Such kind of design may not only improve the quality of electrically conductive material filling in the opening, but also improve the signal integrity of the ready manufactured component carrier.

In an embodiment, the planar extension of the first portion is smaller than the planar extension of the second portion in a direction perpendicular to the thickness direction of the at least one insulating layer structure. In this embodiment the area delimited by the first portion is smaller than the area delimited by the second portion. For example, the first portion may have a smaller diameter than the second portion. This is a footprint of manufacturing of the invention and it may also help to distribute the thermal stress over the two portions, which may improve the stability of opening to avoid an inner crack of the opening.

In an embodiment, the diameter of the first portion is different from the diameter of the second portion. The diameter is meant in a direction perpendicular to the thickness direction of the at least one insulating layer structure. Preferably, the diameter of the first portion is smaller than the diameter of the second portion.

In an embodiment, a step is provided between the first portion and the second portion. Such a step may be constituted by an edge or a corner. In particular, a step is provided in the case, when the planar extensions of the two portions in the direction perpendicular to the thickness direction differs from each other. The step may have a surface which is orientated parallel to the main surface. The surface of the step may face the main surface of the component carrier or the insulating layer structure. The step may help define the shape of the first portion and second portion. With this step, the first and second portion can have a more straight sidewall compared with the state of art. In an embodiment, the first portion comprises a straight shape in an axial cross section of the at least one opening. In a cross section parallel to the middle axis of the opening the first portion may be straight. Preferably in such a cross section the first portion has a linear shape which is directed parallel to the thickness direction of the at least one insulating layer structure. Thus, it may improve the filling with electrically conductive material and the signal transmission efficiency of the ready manufactured component carrier. Alternatively, the straight linear shape in the cross section may also be inclined with regard to the thickness direction.

In an embodiment, the extension in the thickness direction of the first portion is cylindrical. In this embodiment the first portion is not inclined with regard to the thickness direction. Alternatively, also the first portion may have an inclination and comprise a conical extension in the thickness direction.

In an embodiment, the first portion extends in the thickness direction of the at least one insulating layer structure. The first portion may extend straightly in the thickness direction. In such a configuration the first portion may have a cylindrical shape. Such kind of design increases the diameter of the first portion of the opening, so that it may improve the uniformity of filling with electrically conductive material and reduces the risk of a void during the filling. Therefore, it improves the mechanical stability of the opening and the component carrier.

In an embodiment, the lateral wall at one extremity of the first portion is slanted, in particular toward the second portion, in particular wherein the planar extension of a portion of the first portion adjacent to the at least one electrically conductive layer structure is greater than the planar extension of a portion of the first portion adjacent to the second portion in a direction perpendicular to the thickness direction of the at least one insulating layer structure. In this embodiment the first portion is slanted in the way that cross section parallel to the middle extension of the opening, the diameter of the extremity of the first portion adjacent to the second portion is smaller than the diameter at the extremity of the first portion adjacent to the electrically conductive layer structure. In this embodiment the first portion may have a (reversed) conical shape. Such a conical shape increases the contact surface of the opening with the electrically conductive layer structure. Furthermore, the surface of the first portion is increased. The increased surface provides better adhesion of electrically conductive material which is filled into the first portion and the opening. Such kind of design may help to improve the high density package of the component carrier as the smaller diameter at the bottom of the layer can provide more tolerance for opening formation. Thus, it provides more freedom and flexibility for design with high density package due to the higher capability of manufacturing. Besides that, it can reduce the damage of the via bottom during the opening formation.

In an embodiment, the external extremity of the first portion adjacent to the second portion has a shape of an arc. The external extremity of the first portion may comprise the shape of an arc, preferably a flat arc. The arc shaped extremity may be connected to a step which is provided between the first portion and the second portion. The arc shape of the extremity of the first portion may vary in the circumferential direction of the first portion. It is possible that the curvature of the arc is bigger in one area in the circumferential direction than in another area. The arc may provide a smooth transition from the first portion to the step and/or the second portion. Therefore, it insures the complete filling of the whole opening without a risk of a void and therefore improves the signal integrity.

In an embodiment, the lateral wall of the second portion is slanted toward the main surface of the at least one electrically insulating layer structure, in particular wherein the planar extension of a portion of the second portion adjacent to the first portion is smaller than the planar extension of a portion of the second portion adjacent to the main surface of the at least one electrically insulating layer structure in a direction perpendicular to the thickness direction of the at least one insulating layer structure. In this embodiment the second portion has a conical shape which opens to the main surface of the at least one electrically insulating layer structure. Such a conical shape can be formed using laser drilling. Such kind of design may help to improve the high density package of the product as the smaller diameter at the bottom of the layer can provide more tolerance for laser drilling, so it provides more freedom and flexibility for design of high density package due to the higher capability of manufacturing. It is also possible that in combination with a conical shape of the second portion, also the first portion has a conical shape. The conical shape of the first portion may be reversed compared to the conical shape of the second portion. Thus, the two portions together may have the shape of an hourglass. Such a configuration provides an improved adhesion of electrically conductive material filled into the opening, since the contact surface between the opening and the electrically conductive material is increased. Furthermore, the shape of the opening like an hourglass provides a form closure of the electrically conductive material filled into the opening and increases the mechanical stability of the component carrier. Alternatively, also the second portion may not be slanted or conical but comprise a vertical cylindrical shape. Such a kind of design may have a higher accuracy of the opening and reduces the resistance during electricity transmission.

In an embodiment, the extension in the thickness direction of the second portion is conical. Alternatively, the extension of the second portion may be cylindrical. In any case, the whole opening has a less significant conical shape than vias according to prior art since the opening is divided into two portions which extend only over a part of the opening in the thickness direction respectively.

In an embodiment, the roughness of the first portion is different from the roughness of the second portion. This difference in the roughness of the surface between the first portion and the second portion may be an effect of different manufacturing processes which are used to manufacture the first portion and the second portion. To increase the diameter of the first portion and to improve the uniformity of the first portion and the second portion, exposure technology to form the first portion may be applied. The first portion may be formed by exposure and developing on the bottom of the opening, which provides a flat and straight bottom for the second portion formation. The second portion may be formed by a very accurate laser drilling technology (such as excimer laser or UV laser drilling) to form a more straight and consistent size of second portion in the opening. A different roughness of the two portions may be visible in the cross section of the finished component carrier.

In an embodiment, the first portion and the second portion are formed using the same manufacturing process in two successive manufacturing steps. The first and the second portion may be manufactured both using a lithography manufacturing process. This lithography manufacturing process, such as exposure, development and stripping, may be performed two times. The first portion is formed by patterning a dry film by processing with exposure and development. After the bottom of the opening is provided with the remaining dry film, a photosensitive dielectric material (such as solder resist material) is laminated or coated on the remaining dry film. The second lithography process is applied to form the second portion above the dry film by using exposure to polymerize the part of the photosensitive dielectric material and using development to dissolve the unploymerized part of the photosensitive dielectric material for removal of the material to form the second portion. Then the remaining dry film is stripped by using chemical to loosen the connection area between the dry film and other material and then using a high press rinse to peel off the material from the position. As a result, the first portion and the second portion have a different extension one to each other in the thickness direction of the at least one insulating layer structure. However, using the same manufacturing process for both portions may provide a more regular shape of the whole opening than using different manufacturing steps. For example, a conical extension of each of the two portions may be reduced using a lithography process for manufacturing two times. The resulting more consistent shape and size of the opening will benefit for filling the opening with conductive material and for improving the signal integrity of the ready manufactured component carrier. Besides that, the roughness of the surface of the two portions may be different, but the roughness variation of the two portions may be smaller than the roughness variation provided by using different manufacturing processes. Thus, the skin effect in the opening may be reduced, which may reduce the loss of the signal during transmission.

In an embodiment, the roughness of the first portion is lower than the roughness of the second portion. The lower roughness of the first portion may be provided by using a chemical process for forming the first portion. The chemical process is used to remove the material which is for the patterning of first portion and it does not really impact or damage the sidewall morphology of the opening. A higher roughness of the second portion may be in effect of using a drilling process to form the second portion. The second portion is formed by laser drilling which basically burns the material to form a portion of the opening by the laser energy. This burning impacts the morphology or physical property of the material. One the one hand the higher roughness of the second portion can promote the adhesion between the electrically conductive material which will be filled in the opening and the sidewall of the opening. On the other hand, the lower roughness of the first portion can reduce the electrical resistance of the conductive material to improve the transmission quality and efficiency of the signal. Therefore, the different roughness on the two portions can compensate the adhesion and electrical performance with each other in a surprising synergetic effect.

In an embodiment, there is a step between the first portion and the second portion and the roughness of the surface of the step, which faces the main surface of the at least one electrically insulating layer structure is different from the roughness of the first portion. The roughness of a surface of a step may defer from the roughness of the surface of the first portion. Such difference in the roughness can result from different manufacturing processes which are used to form the first portion and the surface of the step. Since the step is formed after first portion was formed and it is formed with the second portion by laser drilling, the step will be also burned by the laser energy which results in a rough surface of the step. With the higher roughness it will promote the adhesion between the electrically conductive material which will be filled in the opening and the sidewall of the opening. It may reduce risk of a crack and/or delamination in or next to the opening.

In an embodiment, the roughness of the surface of the step, is higher than the roughness of the first portion. A higher roughness of the surface of the step may be a result of the drilling process, which is used to form the second portion and the surface of the step. A higher roughness of the surface of the step provides a good adhesion of conductive material which may be filled into the opening. Moreover, the lower roughness of the first portion can compensate the electrical resistance caused by the step in the opening, so that the signal integrity may be improved compared to prior art vias.

In an embodiment, the first portion comprises a constant roughness over its surface. The roughness of the surface of the first portion may be constant or equal without any areas which comprise a higher or lower roughness. Such a constant roughness may be provided using a chemical process, for example a stripping process, to form the first portion.

In an embodiment, the at least one insulating layer structure comprises fillers, in particular wherein the fillers comprise fibers or spheres. The insulating layer structure may comprise fillers which improve the mechanical properties of the layer structure and/or adjust the Dk and Df values of the insulating layer structure. Fillers can, for example, be fibers or spheres. The fibers or spheres may be made of glass or carbon. The fillers may be embedded in the matrix made of resin.

In an embodiment, the first portion is free of exposed fillers. The first portion may have a smooth surface without fillers, which are exposed at the surface. The surface of the first portion may be formed merely by the matrix material of the at least one insulating layer structure. Such a configuration can be provided when chemical process, like stripping, is used to form the first portion. Due to no exposed fillers, the filling of the conductive material in the first portion may be more efficiently and the electrical resistance can be also improved at the same time.

In an embodiment, the second portion comprises exposed fillers and/or fillers seats. In the second portion there may be exposed for loss of filler seats from which fillers were removed. The exposed fillers and/or filler seats effect a higher roughness compared to a surface which does not comprise exposed fillers or filler seats. The exposed fillers or filler seats can be a result of a drilling process which is used to form the second portion. During such a drilling process the matrix as well as the fillers of the at least one insulating layer structure are mechanically and/or thermally stressed. Due to this stress some of the fillers are removed from the matrix. By removing fillers, empty filler seats remain at the surface. In other areas the stress may merely remove the matrix from the fillers and the fillers remain in their seats but are exposed at the surface of the second portion. The fillers exposed at the surface may provide an anchor point for the sidewall and the conductive material filled into the opening to improve the adhesion between the sidewall and the conductive material and to avoid cracks or delamination.

In an embodiment, the surface of the step comprises exposed fillers and/or fillers seats. In the case when there is a step between the first portion and the second portion which has a surface which faces the main surface of the component carrier, also this surface may comprise exposed fillers and/or fillers seats. These exposed fillers and/or fillers seats may be a result of a drilling process used to form the second portion and the step as described related to the preceding embodiment. By using drilling to form a (micro) opening or via provides a big advantage as it can form an opening or via with a diameter of 20-15 µm, in particular 12-8 µm, more in particular 5-2 µm. The limitation of the opening size is not influenced by the fillers inside of the dielectric material as the exposure technology forms the opening (the fillers inside of the photosensitive dielectric material may not be able to be exposed and the chemical ingredients of the developing means cannot dissolve the fillers). More important, the fillers exposed may provide an advantage that the adhesion between the sidewall and the conductive material filled into the opening is improved.

In an embodiment, the first portion and the second portion are situated decentered one to each other in a plane perpendicular to the thickness direction of the at least one insulating layer structure. The center or middle axis of the first portion and the second portion may be offset one to each other. Such a decentering can occur with different manufacturing processes are used to form the first portion and the second portion. Due to different manufacturing processes, a separate alignment has to be done respectively for each process. Thus, there may be tolerances in the alignment which are visible at the finished component carrier in form of a decentering or an alignment shift of the two portions. It provides a flexibility of designing a high density of openings and provides the capability to manufacture the component carrier it with less effort.

In an embodiment, a plurality of openings is provided and there is a planar decentering between the first portion and the second portion of the respective openings in a plane perpendicular to the thickness direction of the at least one insulating layer structure. The first and the second portion of the openings are decentered along different directions one to each other. Such a configuration may be a result of different alignments for manufacturing the first portions and the second portions. With different tolerances in the alignment or the manufacturing accuracy of the different manufacturing processes a position shift between the first portion of the second portion can occur in lower effort. Such a decentering may be equal for all openings or alternatively may be different for at least the part of the openings from another part of the openings. Meanwhile, it provides a big advantage that the product quality and reliability for a high density product for high performance computing can be guaranteed with the technology in house without a big investment for additional technology.

In an embodiment, the at least one electrically insulating layer structure comprises a solder resist, in particular a solder resist layer. A solder resist which delimits the opening prevents solder from adhesion on the main surface of the component carrier. In a configuration with an opening which is filled with conductive material to form an electrically conductive connection, this connection can be used to place a solder bump on top of the component carrier. A solder resist adjacent to the electrically conductive connection and the solder bump prevents that the solder forms a shortcut between two openings. In this way a high package density of openings can be provided without the risk of damages or shortcuts. With such kind of invention, the limitation of openings formed by the conventional method such as exposure in the solder resist can be avoided.

In an embodiment, a conductive material is provided in the at least one opening, in particular wherein the at least one opening is at least partly filled with the conductive material, preferably wherein the conductive material comprises copper. A conductive material within the opening can provide an electrically conductive connection between the at least one electrically conductive layer structure and the main surface of the at least one electrically insulating layer structure. In this way, a via can be formed within the opening. The volume of the conductive material may be the same for different openings or may defer between different openings due to manufacturing tolerances.

In an embodiment, the conductive material fills the at least one opening delimited by the first portion and the second portion. The conductive material may be filled into the first portion and the second portion in a single manufacturing process step, for example by electroplating. Although the first portion and the second portion may have a different diameter, shape or roughness, the conductive material filling can be completed by electroplating in one time with good quality as the invention forms a consistent good shape and size opening.

In an embodiment, the conductive material forms at least a portion of an electrically conductive connection extending in the thickness direction of the at least one electrically insulating layer structure. The electrically conductive connection can form via which connects the at least one electrically conductive structure with the main surface of the component carrier.

In an embodiment, the electrically conductive connection comprises an extending portion, which extends beyond the opening. The extending portion may protrude in the thickness direction over the main surface of the component carrier. The extending portion may form a land or pad for placing a solder bump. The extending portion may formed with the electrically conductive material filled into the opening in the same process, so that it can provide a uniform surface of the extending portion at the same level. Therefore, it may provide a good interface for next level structure formation.

In an embodiment, the extending portion of the electrically conductive connection has a planar extension in a direction perpendicular to the thickness direction of the at least one electrically insulating layer structure which is different, in particular bigger, than the planar extension of the portion of the electrically conductive connection inside the opening (inside the first portion and the second portion) in a direction perpendicular to the thickness direction of the at least one electrically insulating layer structure. An extending portion with a bigger planar extension than the planar extension of the electrically conductive connection with in the opening may form a pad or a land on top of the main surface of the component carrier. Furthermore, an extending portion, which protrudes over the electrically conductive connection within the opening provides a good fixture or adhesion of the electrically conductive connection within the electrically insulating layer structure. Generally, the extending portion may comprise a other material as an intermediate layer different from the electrically conductive material to protect the electrically conductive structure and prevent ions of electrically conductive structure migrating to the external as it may impact the soldering performance afterwards, as well as comprise soldering material such as solder bump. The bigger planar extension may provide a proper interface for the intermediate layer and solder bump formation since the intermediate layer and the solder bump may be provided in different processes than the extending portion. The extending portion finally impacts the height and the uniformity of the soldering or bonding structure. Moreover, the bigger planar extension is also aligned with the size of component which will connect with the extending portion.

In an embodiment, the extending portion comprises a connection material, in particular nickel and tin material for soldering, at its external extremity, which faces the opening. The connection material may be provided and applied as solder bump comprising nickel and tin (the nickel and tin may be formed at the same process with good adhesion and provide a good bonding interface for the component) on top of the external extremity of the extending portion.

In an embodiment, a component is connected to the electrically conductive connection, preferably to its extending portion. A component, preferably a high-end active component like an IC-chip, may be connected to the electrically conductive connection. This connection may be done in a soldering process.

In an embodiment, the stack comprises a plurality of electrically insulating layer structures and a plurality of electrically conductive layer structures. Additional to the at least one electrically conductive layer structure and the at least one electrically insulating layer structure there may be provided a plurality of layer structures which are connected to a stack. In this way a plurality of functions can be provided for the component carrier.

In an embodiment, the at least one electrically insulating layer structure comprising the at least one opening is an outermost layer of the stack, preferably an outermost upper layer of the stack. In a case when the opening is provided in an outermost layer of the stack, the opening may be used to form an electrically conductive connection or a via, which connects structures within the component carrier with the main surface thereof.

In an embodiment, an outermost bottom layer of the stack on the main surface opposed of the at least one electrically insulating layer structure comprising the at least one opening is provided, said outermost bottom layer comprises at least one bottom opening, wherein said at least one bottom opening is different from the at least one opening. And outermost layer on the main surface opposing the main surface with the opening may be provided to connect the component carrier to additional components or additional component carriers. For such a connection there is provided at least one bottom opening which connects the main surface opposed to the opening within electrically conductive layer structure within the component carrier. The size, the shape and the extension of the bottom opening differs from the at least one opening in the outermost top layer of the component carrier. Furthermore, the number of the bottom openings may differ from the number of the openings. The middle axis of the at least one bottom opening may be offset with respect to the middle axis of the at least one opening. The bottom opening may serve to form an electrical connection of the component carrier with a passive component, such as a capacitor or an inductor, or with an additional component carrier.

In an embodiment, the at least one bottom opening is delimited by a lateral wall, which extends continuously, preferably extends continuously in the thickness direction of the outermost bottom layer, in particular wherein this lateral wall does not comprise a step. The bottom opening may be manufactured in a single manufacturing step. Thus, the bottom opening comprises a continuous extension. Preferably, the bottom opening does not comprise a first portion and a second portion. The bottom opening can, for example, be manufactured or formed by exposure of the outermost layer of the stack, which faces away from the outermost layer comprising the opening. The bottom opening may have a tapered shape. Since the requirements regarding the connection using the bottom opening are less than the requirements for the connection using the opening due to the element which is connecting with the bottom opening is with lower density, the bottom opening may be manufactured in a simple standard manufacturing process

In an embodiment, the at least one bottom opening has a planar extension in a direction perpendicular to the thickness direction of the outermost bottom layer which is different to the planar extension of the at least one opening, in particular to the planar extension of the first portion and/or the second portion in a direction perpendicular to the thickness direction of the at least one insulating layer structure. The planar extension or area of the bottom opening may differ from the planar extension or area of the opening. Preferably, the planar extension of the bottom opening is bigger than the planar extension of the opening. The bottom opening is provided to connect a passive component or an additional component carrier to the component carrier. Such a connection requires a lower package density than a connection of an active, high-end component which is to be connected with the at least one opening. Therefore, as a result of lower requirement to package density, the planar extension of the bottom opening may be bigger than the planar extension of the at least one opening. With such kind of design, it can provide a big advantage that the bottom side of the component carrier can be manufactured in less process steps and with less effort to produce it, so that the yield can be improved and cost can be reduced. Moreover, the high density at the top side of the component carrier and the lower density at the bottom side can fulfill the requirement of the high performance computing product with less manufacturing cost.

In an embodiment of the method, forming the least one opening is done in the method steps:
applying a protective layer on top of the at least one electrically conductive layer structure;
removing a part of the protective layer, wherein another part of the protective layer remains on the at least one electrically conductive layer structure;
applying at least one insulating layer (e.g. a photosensitive dielectric material) on top of the at least one electrically conductive layer structure and the remaining part of the protective layer;
drilling at least one blind hole into the at least one insulating layer on top of the at least one electrically conductive layer structure and the remaining part of the protective layer, wherein a second portion of an opening is formed, wherein the second portion extends from a main surface of the at least one electrically insulating layer to the remaining part of the protective layer; removing the remaining part of the protective layer through the second portion, wherein a first portion of the opening is formed which extends from the second portion to the at least one electrically conductive layer structure, wherein the first portion and the second portion constitute a lateral wall of the opening. In this embodiment of the method a protective layer is applied and formed to provide a negative form of the first portion of the opening. The protective layer may be a dry film made of photosensitive material. The protective layer is applied, preferably over the total surface of the electrically conductive layer structure on top of the stack of layers. The protective layer is partly removed by exposure and development so that only a part of the protective layer remains in some areas of the electrically conductive layer structure. Afterwards, an insulating layer is applied on top of the remaining part of the protective layer and the electrically conductive layer structure. The second portion of the opening is formed by drilling into the top surface of the insulating layer. The drilling process is directed in the thickness direction and is stopped, with the remaining part of the protective layer is reached. In the next manufacturing step, the remaining part of the protective layer is removed to form the first portion of the opening. This removing of the remaining part of the protective layer is done by a chemical process such as stripping through the already manufactured second portion. By forming the first portion and the second portion, the at least one electrical insulating layer structure as an outermost layer of the component carrier is formed in the applied electrically insulating layer.

In an embodiment of the method, the protective layer is a dry film, in particular a photosensitive dry film. A dry film can be easily applied and formed by exposure and development. Forming by exposure and development provides a regular shape of the remaining part of the protective layer. Since the remaining part of the protective layer forms a negative form (the remaining part is polymerized) of the first portion, a regular shape of the first portion after removing the remaining part of the protective layer can be provided.

In an embodiment of the method, removing a part of the protective layer is done after steps of exposure and developing of the protective layer. Removing a part of the protective layer may be done using a chemical process for example a stripping process by a chemistry to make the connection between the protective layer and other material loose, then using a high pressure rinse to remove the loosed protective layer. After the chemical process, only a part of the protective layer remains on top of the electrically conductive layer structure.

In an embodiment of the method, applying at least one insulating layer on top of the at least one electrically conductive layer structure is done by laminating the at least one insulating layer on top of the other layers. For the laminating, heat and/or pressure is applied to connect the insulating layer with the other layers. Alternatively, the insulating layer can be applied in the viscous state, for example by spraying or coating.

In an embodiment of the method, drilling of the at least one blind hole is done by laser drilling, in particular by excimer laser drilling or UV laser drilling. Laser drilling is an efficient process to form a blind hole which allows to manufacture the second portion in a quick and accurate way. It also can form a very small (micro) hole or via (it can form a via or hole minimum diameter of 2µm in the insulating material).

In an embodiment of the method, removing the remaining part of the protective layer through the second portion is done by a chemical process step, preferably by stripping. By using a chemical process, such as stripping, the surface of the four first portion is not mechanically stressed. Therefore, a smooth surface with a constant roughness can be achieved for the first portion of the opening. Furthermore, using a chemical process also allows to form an undercut of the first portion with regard to the second portion.

In an embodiment of the method, the at least one opening with the first portion and the second portion is filled with conductive material, preferably by electroplating, wherein an electrically conductive connection is formed inside the opening, in particular wherein electrically conductive connection comprises an extending portion, which extends beyond the opening. The opening is filled with conductive material to form an electrically conductive connection which may constitute a via. A via provided in this way has significantly improved properties regarding signal integrity performance compared with a via which is formed in an opening which was created by a single drilling process.

In an embodiment of the method, a connection material, in particular a solder, is applied to the electrically conductive connection, preferably to the extending portion, which extends beyond the opening. In this embodiment as a final of one of the final manufacturing steps of the component carrier, a connection material is applied to the electrically conductive connection within the opening. The connection material may, for example, be a solder bump placed on top of the electrically conductive connection.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), a panel and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a sectional side view of a component carrier according to an exemplary embodiment of the invention.
Figure 2 shows a shows a sectional side view of a component carrier according prior art.
Figure 3 shows a sectional side view of a first state during manufacturing of a component carrier according to an exemplary embodiment of a method of manufacturing a component carrier.
Figure 4 shows a sectional side view of a second state during manufacturing of a component carrier according to an exemplary embodiment of a method of manufacturing a component carrier.
Figure 5 shows a sectional side view of a third state during manufacturing of a component carrier according to an exemplary embodiment of a method of manufacturing a component carrier.
Figure 6 shows a sectional side view of a fourth state during manufacturing of a component carrier according to an exemplary embodiment of a method of manufacturing a component carrier.
Figure 7 shows a sectional side view of a fifth state during manufacturing of a component carrier according to an exemplary embodiment of a method of manufacturing a component carrier.
Figure 8 shows a sectional side view of a component carrier according to an exemplary embodiment of the invention during manufacturing.
Figure 9 shows in a sectional side view a detail of an exemplary embodiment of the invention.

### Detailed Description of the Drawings

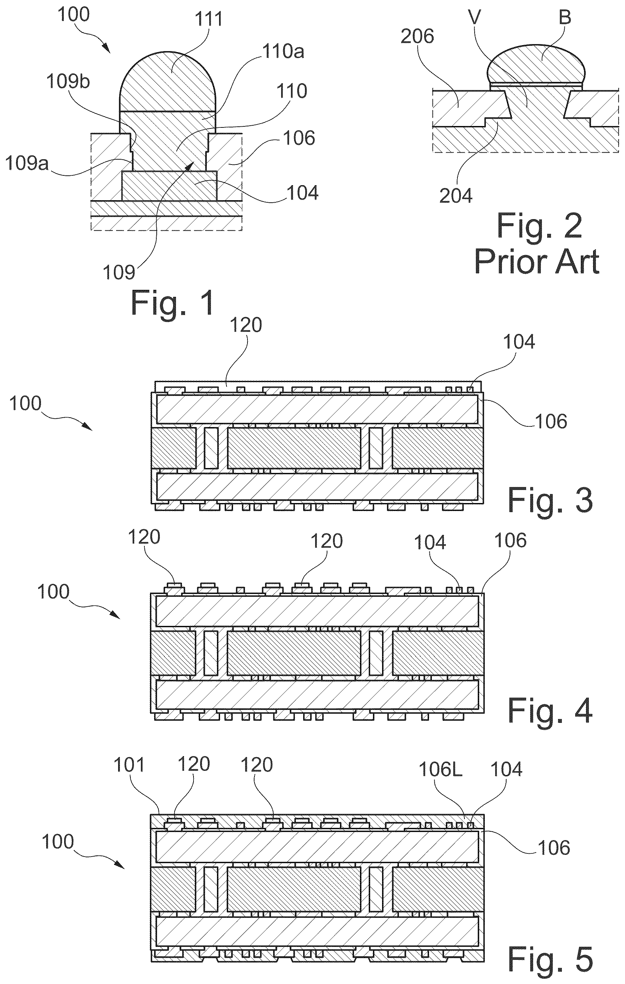

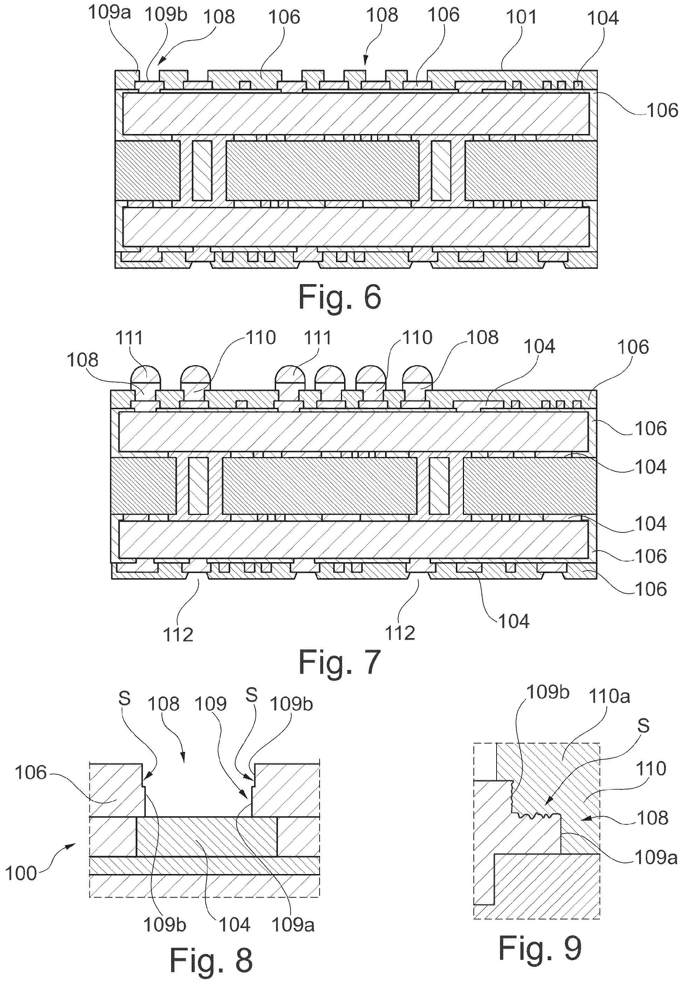

**Figure 1** shows a sectional side view of a component carrier 100 according to an exemplary embodiment of the invention. In Figure 1 a part of the component carrier 100 is illustrated. The component carrier 100 comprises at least one electrically insulating layer structure 106. In the illustrated embodiment, this electrically insulating layer structure 106 is formed by a solder resist, in particular a solder resist layer. The component carrier 100 further comprises at least one electrically conductive layer structure 104, which is situated at the bottom of the electrically insulating layer structure 106 or at least partly within the electrically insulating layer structure 106. The electrically conductive layer structure 104 may comprise pads, traces and other conductive patterns. An opening 108 connects an upper main surface 101 of the electrically insulating layer structure 106 with the electrically conductive layer structure 104. The opening 108 is delimited by a lateral wall 109. The lateral wall 109 comprises two portions: A first portion 109a adjacent to the electrically conductive layer structure 104 and a second portion 109b adjacent to the main surface 101. The second portion 109b is situated above the first portion 109a. In the thickness direction of the insulating layer structure 106 the first portion 109a is situated adjacent to the second portion 109b. The two portions 109a, 109b have a different extension one to each other in the thickness direction of the insulating layer structure 106. In the illustrated embodiment this different extension is a different inclination, a different shape and a different planar extension in a direction perpendicular to the thickness direction of the insulating layer structure 106. Details regarding the different extensions of the two portions 109a, 109b one to each other are described referring to Figure 8.

In the embodiment shown in figure 1 the opening 108 is totally filled with electrically conductive material to form an electrically conductive connection 110 extending in the thickness direction from the electrically conductive layer structure 104 to the main surface 101. The electrically conductive material within the opening 108 extends in the thickness direction and also forms an extending portion 110a of the electrically conductive connection 110. This extending portion 110a protrudes in the thickness direction over the main surface 101. In the illustrated embodiment the extending portion 110a has a planar extension in a direction perpendicular to the thickness direction which is bigger than the planar extension of the portion of the electrically conductive connection 110 inside the opening 108, in particular inside the first portion 109a and the second portion 109b. Thus, a part of the extending portion 110a covers the main surface 101. Furthermore, the extending portion 110a also protrudes over the lateral wall 109 of the opening 108 in the direction perpendicular to the thickness direction. The external extremity of the extending portion 110a, which faces the opening 108, comprises a connection material 111. In the illustrated embodiment the connection material 111 is a solder and forms a solder bump at the surface of the electrically conductive connection 110 which faces away from the electrically conductive layer structure 104. The connection material 111 can be used to connect a component to the component carrier 100 by soldering. In the embodiment illustrated in Figure 1 the opening 108 is formed in an electrically insulating layer structure 106 which is an outermost layer of the stack of layers of the component carrier 100. The two portions 109a, 109b of the lateral wall 109 of the opening 108 are clearly visible also in a state in which electrically conductive material is already filled into the opening 108 and forms the electrically conductive connection 110.

**Figure 2** shows a sectional side view of a component carrier according to prior art. The illustrated portion of the component carrier comprises a solder bump B which is connected by a via V with an electrically conductive layer structure 204. The via V was formed by drilling an opening into the electrically insulating layer structure 206 using laser drilling. The opening comprises an irregular shape in the thickness direction of the insulating layer structure 206. Due to the manufacturing by laser drilling, the opening has a conical shape. The size of the opening next to the upper main surface of the electrically insulating layer structure 206 is bigger than the size of the opening adjacent to the electrically conductive structure 204. Such an irregular shape of the via V leads to an inferior signal integrity performance of the connection between the solder bump B and the electrically conductive layer structure 204 especially for a high performance computing product. By increasing the power of the laser beam for laser drilling, the shape of the via V may be improved so that the shape is less conical. However, such an increase of power of the laser beam may lead to damages or delamination of the top layers of the component carrier.

Figures 3 to 7 show different states during manufacturing of a component carrier 100 using a method of manufacturing the component carrier according to the invention.

**Figure 3** shows a sectional side view of a first state during manufacturing of a component carrier 100 according to an exemplary embodiment of a method of manufacturing a component carrier 100. The component carrier 100 shown in the first state already comprises a plurality of electrically insulating layer structures 106 and a plurality of electrically conductive layer structures 104. These layers are connected to a stack. Furthermore, the component carrier 100 may comprise embedded components. The following description refers to manufacturing of the upper outermost layer of the component carrier 100 which will comprise several openings 108 according to the invention in later stages of manufacturing.

Figure 3 shows a first state during manufacturing. A protective layer 120 was applied on top of the uppermost electrically conductive layer structure 104 of the stack. This protective layer 120 will be used to form a first portion 109a of an opening 108. The protective layer 120 is constituted by a dry film. Starting from the first state shown in Figure 3, the protective layer 120 is exposed and developed. The exposure is done only at the part of the surface area of the protective layer 120, wherein another part of the protective layer is not exposed. After the exposure and the development a part of protective layer 120 is removed wherein another part of the protective layer 120 remains on the electrically conductive layer structure 104. Removing a part of the protective layer 120 is done by a chemical process, for example by stripping process.

**Figure 4** shows a sectional side view of a second state during manufacturing of a component carrier 100 according to an exemplary embodiment of a method of manufacturing a component carrier 100. In the second state shown in figure 4 a part of the protective layer 120 applied in the state shown in Figure 3 was removed. Only a part of the protective layer 120 remains on top of the electrically conductive layer structure 104. The (lateral wall of the) remaining parts of the protective layer 120 already have the size and the shape of the first portion 109a of an opening 108 which will be formed in the next manufacturing steps. The (lateral wall of the) remaining parts of the protective layer 120 constitute a negative form of the first portion 109a. The planar extension or the diameter of the remaining parts of the protective layer 120 can be defined and adjusted during exposure of the protective layer 120.

**Figure 5** shows a sectional side view of a third state during manufacturing of a component carrier 100 according to an exemplary embodiment of a method of manufacturing a component carrier 100. Starting from the second state shown in Figure 4, an insulating layer 106L was applied on top of the upper most electrically conductive layer structure 104 and the remaining part of the protective layer 120. The insulating layer 106L covers the total upper surface of the component carrier 100. After applying the insulating layer 106L, the upper surface of this layer forms a main surface 101 of the component carrier 100. In the third state shown in Figure 5 the remaining part of the protective layer 120 and the electrically conductive layer structure 104 are embedded within the insulating layer 106L. Applying the insulating layer 106L on top of the electrically conductive layer structure 104 has been done by laminating the at insulating layer 106L on top of the other layers. Alternatively, the insulating layer 106L may be applied in the viscous state, for example in the form of a resin. In the illustrated embodiment the insulating layer 106L is a solder resist which is a photosensitive dielectric material and comprises fillers.

**Figure 6** shows a sectional side view of a fourth state during manufacturing of a component carrier 100 according to an exemplary embodiment of a method of manufacturing a component carrier 100. In the illustrated fourth state several openings 108 have been formed in the insulating layer 106L, which is visible in Figure 5. At first, the second portion 109b was formed by drilling a blind hole into the insulating layer 106L. The drilling was done by laser drilling, in particular by excimer laser drilling. An UV laser may be also applicable to form the second portion 109b depending on the size of the opening 108. The drilling of the blind hole started at the main surface 101 and was directed in the thickness direction of the insulating layer 106L. The drilling was stopped when the blind hole reached the remaining part of the protective layer 120. At an intermediate stage during forming the opening 108, merely as the second portion 109b was formed extending from the main surface 101 to the remaining part of the protective layer 120. After forming the second portion 109b, the first portion 109a was formed by removing the remaining part of the protective layer 120 through the second portion 109b. Removing the remaining part of the protective layer 120 was done by a chemical process step, in particular a stripping step. The fourth state shown in Figure 6 shows the openings 108 in a finished state, when they comprise a lateral wall 109 comprising a first portion 109a and a second portion 109b. By forming the openings 108, the insulating layer 106L is transformed into an electrically insulating layer structure 106. The two portions 109a, 109b have a different extension one to each other in the thickness direction of the insulating layer structure 106. The different extension one to each other of the two portions 109a, 109b is not visible in Figures 6 and 7. Details regarding these two portions 109a, 109b are shown in Figures 8 and 1 and are described in the respective description of these Figures.

**Figure 7** shows a sectional side view of a fifth state during manufacturing of a component carrier 100 according to an exemplary embodiment of a method of manufacturing a component carrier 100. The fifth state illustrated in Figure 7 shows the component carrier 100 in a finished state. Starting from the fourth state illustrated in Figure 6, the openings 108 have been filled with conductive material by electroplating. The conductive material constitutes an electrically conductive connection 110 in each of the openings 108. The electrically conductive connection 110 comprises an extending portion 110a which extends beyond the opening 108 in the thickness direction of the insulating layer structure 106. Furthermore, a connection material 111 has been applied to the electrical connection 110. The connection material 111 is a solder and forms a solder bump on top of each electrically conductive connection 110. Details regarding the electrically conductive connection 110 are described referring to Figure 1.

In the finished state of the component carrier 100 illustrated in Figure 7 several bottom openings 112 are situated in an outermost bottom layer, which is opposed to the electrically insulating layer structure 106 comprising the openings 108. Each of the bottom openings 112 is delimited by a lateral wall, which extends continuously in the thickness direction of the outermost bottom layer of the stack. The bottom opening 112 differs from the opening 108 in the outermost top layer of the stack. The bottom opening 112 has been formed in a single step, preferably by exposure. The bottom opening 112 does not comprise two different portions. Thus, there is also no step S in the lateral wall of the bottom opening 112. The bottom opening 112 has a planar extension in a direction perpendicular to the thickness direction of the outermost bottom layer which is different to the planar extension of the opening 108, in particular to the planar extension of the first portion 109a and/or the second portion 109b in a direction perpendicular to the thickness direction of the insulating layer structure 106 which forms the outermost top layer of the stack. The bottom openings 112 are intended for connection of the component carrier 100 with passive components, for example a capacitors and inductors, or bigger (solder) bumps to connect with another component carrier which has lower density. The bottom openings 112 are manufactured in the simple process, since there are less requirements to the bottom openings 112 regarding signal integrity performance since it connects with the lower density elements. In contrast, the openings 108 in the outermost top layer, the electrically insulating layer structure 106, have an optimized shape due to the two portions 109a, 109b. The openings 108 with their electrically conductive connection 110 comprises a significantly higher signal integrity performance than the bottom openings 112. The process for manufacturing the openings 108 comprises more steps than the manufacturing of the bottom openings 112. However, the openings 108 significantly improve the behavior of the component carrier 100 for connections with high-end components, which can be connected to the component carrier 100 using the connection material 111 as solder bumps.

**Figure 8** shows a sectional side view of a component carrier 100 according to an exemplary embodiment of the invention during manufacturing. In the state of manufacturing shown in Figure 8, the component carrier 100 comprises an opening 108 which is not yet filled with electrically conductive material. The opening 108 is delimited by a lateral wall 109. At the bottom, the opening 108 is delimited by a part of the electrically conductive layer structure 104. The opening 108 and/or the lateral wall 109 comprises a first portion 109a and the second portion 109b, wherein the first portion 109a is closer to the at least one electrically conductive layer structure 104 and the second portion 109b is closer to the main surface 101 of the at least one electrically insulating layer structure 106. The first portion 109a and the second portion 109b are situated adjacent to each other in the thickness direction of the insulating layer structure 106. The two portions 109a, 109b have a different extension one to each other in the thickness direction of the insulating layer structure 106. In the illustrated embodiment, the second portion 109b comprises a different inclination than the first portion 109a. The second portion 109b comprises a slight conical shape, wherein the second portion 109b is slanted toward the main surface 101 of the electrically insulating layer structure 106 (the second portion may be also with straight sidewall), in particular wherein the planar extension of a portion of the second portion 109b adjacent to the first portion 109a is smaller than the planar extension of a portion of the second portion 109b adjacent to the main surface 101 in a direction perpendicular to the thickness direction of the insulating layer structure 106. The first portion 109a extends in a straight shape so that its extension in the thickness direction is cylindrical. Thus, the different extension of the two portions 109a, 109b is also a different shape one to each other. It is also possible that the first portion 109a also comprises a conical shape. However, the conical shape of the first portion 109a may differ from the conical shape of the second portion 109b. The first portion 109a at one extremity of the first portion 109a may be slanted, in particular from the electrically conductive layer structure 104 to the second portion 109b, in particular wherein the planar extension of a portion of the first portion 109a adjacent to the electrically conductive layer structure 104 is greater than the planar extension of a portion of the first portion 109a adjacent to the second portion 109b in a direction perpendicular to the thickness direction of the insulating layer structure 106. Furthermore, the planar extension of the first portion 109a in a direction perpendicular to the thickness direction of the insulating layer structure 106 is smaller than the planar extension of the second portion 109b. Due to this different extensions in a direction perpendicular to the thickness direction of the two portions 109a, 109b a step S is provided between the first portion 109a and the second portion 109b. The step S and the different shapes or extensions of the first portion 109a and the second portion 109b are clearly visible in a cross section as shown in Figures 8 and 1.

In the illustrated embodiment, the roughness of the first portion 109a is different from the roughness of the second portion 109b. The roughness of the first portion 109a is lower than the roughness of the second portion 109b. This different roughness are a result of different manufacturing processes which are used to manufacture the first portion 109a and the second portion 109b. The first portion 109a is manufactured by a chemical process, preferably by stripping. Thus, the surface of the first portion 109a is smooth and comprises a low roughness. In the illustrated embodiment the insulating layer structure 106 comprises fillers, which may be constituted by spheres. The first portion 109a is free of exposed fillers, since the first portion 109a was formed by a chemical process there was no mechanical deformation or abrasion during the manufacturing process. Therefore, the fillers adjacent to the first portion 109a were not stressed during manufacturing and kept their position embedded in the insulating layer structure 106. Preferably, no fillers protrude over the surface of the first portion 109a. Thus, the first portion 109a comprises a constant roughness over its surface. However, the second portion 109b was manufactured by drilling. During drilling the electrical insulating layer structure 106 with its embedded fillers was mechanically and/or thermally stressed. Thus, some of the fillers may be removed from their seats and are no longer embedded within the electrically insulating layer structure 106. After drilling the second portion 109b comprises exposed fillers and/or exposed filler seats. Filler seats are cavities, which contained a filler, which was removed during the drilling process. A different roughness between the first portion 109a and the second portion 109b is a result of the different manufacturing processes and is visible in the cross section of the opening 108. The step S between the first portion 109a and the second portion 109b comprises a roughness, which differs from the roughness of the first portion 109a. The surface of the step S which faces the main surface 101 of the electrically insulating layer structure 106 comprises a higher roughness than the first portion 109a, since also the surface of the step S was manufactured in the drilling process. Details regarding the roughness of the surface of the step S are described referring to figure 9.

In the embodiment shown in Figure 8 the electrically insulating layer structure 106 is a solder resist layer with embedded fillers. Preferably, the opening 108 with its lateral wall 109 is situated in an outermost layer of the stack of layers, which constitute the component carrier 100.

**Figure 9** shows in a sectional side view a detail of an exemplary embodiment of the invention. The illustrated detail shows a step S between a first portion 109a and the second portion 109b of an opening 108. The opening 108 and its lateral wall 109 correspond to the embodiments shown in Figures 1 and 8. Thus, also the description regarding Figures 1 and 8 is valid for the elements shown in Figure 9. In the detail in figure 9 it is visualized that the surface of the step S comprises a high roughness. As explained referring to Figure 8, the second portion 109b was manufactured by a drilling process. The surface of the step S which extends in a horizontal direction and faces the main surface 101 of the electrically insulating layer structure 106 was also formed during the drilling process to manufacture the second portion 109b. The surface of the step S was mechanically stressed during the drilling process so that some of the fillers which were embedded in the electrically insulating layer structure 106 were removed or damaged. Thus, also the surface of the step S comprises exposed fillers and/or filler seats. This results in an increased roughness of the surface of the step S compared with the smooth surface of the first portion 109a. The higher roughness of the surface of the step S provides a good adhesion of the conductive material which fills the opening 108 and constitutes an electrically conductive connection 110. The electrically conductive connection 110 was formed in an electroplating process. The conductive material of the electrically conductive connection 110 follows the rough surface of the step S. In this way, a form closure between the rough surface of the step S and the electrically conductive connection 110 is provided. This form closure ensures a good adhesion of the electrically conductive connection 110 within the opening 108. Therefore, a delamination or separation of the electrically conductive connection 110 from the electrically insulating layer structure 106 can be efficiently prevented. The higher roughness of the surface of the step S and of the second portion 109b approves the mechanical stability and durability of the component carrier 100.

### Reference signs

- 100: component carrier
- 101: main surface
- 104: electrically conductive layer structure
- 106: insulating layer structure
- 106L: insulating layer
- 108: opening
- 109: lateral wall
- 109a: first portion
- 109b: second portion
- 110: electrically conductive connection
- 110a: extending portion
- 111: connection material
- 120: protective layer
- 204: electrically conductive layer structure
- 206: insulating layer structure
- B: solder bump
- S: step
- V: via

## Claims

1. A component carrier (100), comprising:
at least one electrically insulating layer structure (106) and at least one electrically conductive layer structure (104);
wherein said at least one electrically insulating layer structure (106) comprises at least one opening (108) which connects a main surface (101) of the at least one electrically insulating layer structure (106) with at least part of the at least one electrically conductive layer structure (104), said at least one opening (108) being delimited by a lateral wall (109), said lateral wall (109) comprising two portions, a first portion (109a) and a second portion (109b), one above the other in a thickness direction of the at least one electrically insulating layer structure (106),
wherein said two portions (109a, 109b) have a different extension one to each other in the thickness direction of the at least one electrically insulating layer structure (106).

2. The component carrier (100) according to claim 1, wherein the different extension of the two portions (109a, 109b) is a different inclination one to each other with respect to the thickness direction of the at least one electrically insulating layer structure (106).

3. The component carrier (100) according to one of the preceding claims, wherein the different extension of the two portions (109a, 109b) is a different shape one to each other.

4. The component carrier (100) according to one of the preceding claims, wherein the planar extension of the first portion (109a) is different from the planar extension of the second portion (109b) in a direction perpendicular to the thickness direction of the at least one electrically insulating layer structure (106), in particular wherein the planar extension of the first portion (109a) is smaller than the planar extension of the second portion (109b) in a direction perpendicular to the thickness direction of the at least one electrically insulating layer structure (106) and/or
wherein the diameter of of the first portion (109a) is different from the diameter of the second portion (109b)

5. The component carrier (100) according to one of the preceding claims, wherein a step (S) is provided between the first portion (109a) and the second portion (109b).

6. The component carrier (100) according to one of the preceding claims, wherein the first portion (109a) comprises a straight shape in an axial cross section of the at least one opening (108).

7. The component carrier (100) according to one of the claims 1 to 5, wherein the lateral wall (109) at one extremity of the first portion (109a) inclines toward the second portion (109b), in particular wherein the planar extension of a portion of the first portion (109a) adjacent to the at least one electrically conductive layer structure (104) is greater than the planar extension of a portion of the first portion (109a) adjacent to the second portion (109b) in a direction perpendicular to the thickness direction of the at least one electrically insulating layer structure (106).

8. The component carrier (100) according to one of the preceding claims, wherein the roughness of the first portion (109a) is different from the roughness of the second portion (109b), in particular
wherein the roughness of the first portion (109a) is lower than the roughness of the second portion (109b).

9. The component carrier (100) according to claim 5, wherein the roughness of the surface of the step (S), is different from the roughness of the first portion (109a).

10. The component carrier (100) according to one of the preceding claims, wherein the at least one electrically insulating layer structure (106) comprises fillers, in particular wherein the fillers comprise spheres, in particular wherein the first portion (109a) is free of exposed fillers.

11. The component carrier (100) according to one of the preceding claims, wherein the second portion (109b) comprises exposed fillers and/or fillers seats.

12. The component carrier (100) according to one of the claims 5 or 9, wherein the surface of the step (S) comprises exposed fillers and/or fillers seats.

13. The component carrier (100) according to one of the preceding claims, wherein a conductive material is provided in the at least one opening (108), in particular wherein the at least one opening (108) is at least partly filled with the conductive material, preferably wherein the conductive material comprises copper.

14. The component carrier (100) according to one of the preceding claims, wherein the stack comprises a plurality of electrically insulating layer structures (106) and a plurality of electrically conductive layer structures (104), in particular wherein the at least one electrically insulating layer structure (106) comprising the at least one opening (108) is an outermost layer of the stack, preferably an outermost upper layer of the stack.

15. A method of manufacturing a component carrier (100), wherein the method comprises:
forming a stack comprising at least one electrically conductive layer structure (104) and at least one electrically insulating layer structure (106);
forming least one opening (108) which connects a main surface (101) of the at least one electrically insulating layer structure (106) with at least part of the at least one electrically conductive layer structure (104), said at least one opening (108) being delimited by a lateral wall (109), said lateral wall (109) comprising two portions, a first portion (109a) and a second portion (109b), one above the other in a thickness direction of the at least one electrically insulating layer structure (106),
wherein said two portions (109a, 109b) have a different extension one to each other in the thickness direction of the at least one electrically insulating layer structure (106).
